# EUROPÄISCHE PATENTSCHRIFT

(11) **EP 0 942 637 B1**
(45) Veröffentlichungstag und Bekanntmachung des Hinweises auf die Patenterteilung: **20.10.2004**
(21) Anmeldenummer: 99102485.2
(22) Anmeldetag: 10.02.1999
(51) Int. Cl.: H05K 7/14

(54) **Steuerungsanlage für elektronische Steuerungs- und Automatisierungssysteme**
Apparatus for electronic control and automation systems
Appareillage pour systèmes d'automatisation à commande électronique

(30) Priorität: 11.03.1998 DE 29804284 U
(43) Veröffentlichungstag der Anmeldung: 15.09.1999
(73) Patentinhaber: Weidmüller Interface GmbH & Co., 32760 Detmold (DE)
(72) Erfinder: Hanning, Walter, 32758 Detmold (DE); Richts, Jörg, 33189 Schlangen (DE); Wilmes, Manfred, 32760 Detmold (DE)
(74) Vertreter: Stracke, Alexander, Dipl.-Ing.

(56) Entgegenhaltungen:
- DE-A- 3 527 677
- DE-C- 4 410 817
- DE-C- 4 438 806
- DE-U- 9 406 386

## Beschreibung

Die vorliegende Erfindung betrifft eine Steuerungsanlage für elektronische Steuerungs- und Automatisierungssyteme gemäß Oberbegriff des Anspruches 1.

Derartige Steuerungsanlagen dienen dazu, die Steuerung z. B. für eine Maschine oder eine Produktionsanlage mit den in der Peripherie verteilten installierten Initiatoren, Aktoren, Feldgeräten oder dergleichen elektrisch zu verbinden.

Bei einer bekannten derartigen Steuerungsanlage (DE 44 38 806 C1), die modular aufgebaut ist und bei der der Anschlußblock jeweils aus einer Anzahl anreihbarer Anschlußscheiben gebildet ist, geschieht die mechanische Verbindung zwischen dem Elektronikmodul und dem Anschlußblock mit Hilfe von T-nutenförmigen Führungen an einer Verbindungsfläche des Anschlußblockes und T-Nutengegenstücken am Gehäuse des Elektronikmodules andererseits. Beim Ineinanderstecken werden darüber hinaus Rasten wirksam.

Bei rauhem Werkstattbetrieb und längerer Betriebsdauer kann die bekannte Verrastung mittels Rasthaken unzureichend sein, da Letztere ihre Stabilität verlieren können und im Extremfall auch ausbrechen können. Andererseits würde eine erhebliche Erhöhung der Anzahl der Rasthaken oder eine nennenswerte Erhöhung ihrer Rastkraft zu unzulässig hohen Betätigungskräften für die Steckverbindung führen.

Der vorliegenden Erfindung liegt von daher die Aufgabe zugrunde, eine Steuerungsanlage der gattungsgemäßen Art zu schaffen, die auf einfache Weise ohne Erhöhung der Betätigungskraft eine sichere mechanische Verbindung zwischen dem Anschlußblock und dem Elektronikmodul gewährleistet. Die erfindungsgemäße Lösung ergibt sich aus dem Anspruch 1. Der Einsatz eines gesonderten Sicherungselementes ist im Ergebnis außerordentlich handhabungsbequem. Eine bauliche Verkomplizierung stellt sich nicht ein, da das gesonderte Sicherungselement mit den vorhandenen T-nutenförmigen Führungen zusammenwirkt. Mit dem Sicherungselement läßt sich eine zuverlässige Blockierung des eingesteckten Elektronikmoduls auch für rauhen Werkstattbetrieb gewährleisten.

Bevorzugte und zweckmäßige weitere Ausgestaltungen des Gegenstandes der Erfindung sind in den Unteransprüchen gekennzeichnet. So ist in sehr zweckmäßiger Ausgestaltung das Sicherungselement in seiner Außenkontur so bemessen, daß es genau zwischen die am Elektronikmodul vorhandenen T-Nutengegenstücke paßt.

Von besonderem Vorteil ist auch, daß das Sicherungselement aus einem einteiligen Grundkörper mit zwei darin verschieblich geführten Schieberelementen besteht. In der Gesamtschau genügt nach Einsetzen des Sicherungselementes und Einstecken des Elektronikmodules somit eine kurze, einfach durchzuführende Verschiebung der Schieberelemente in die Blockierlage über die beiden T-Nutengegenstücke des Elektronikmoduls.

In weiterer sehr zweckmäßiger Ausgestaltung kann das Sicherungselement selbst mittels Rasthaken in entsprechenden Rastaussparungen, die im Verlauf der T-nutenförmigen Führungen vorgesehen sind, festgesetzt werden.

Ein Ausführungsbeispiel einer erfindungsgemäßen Steuerungsanlage wird nachstehend unter Bezugnahme auf die Zeichnung näher beschrieben.

Es zeigen:
- Figur 1: ein Sicherungselement der erfindungsgemäßen Steuerungsanlage in sprengbildlicher Darstellung, in einer Montagephase sowie in montiertem Zustand in perspektivischer Seitenansicht,

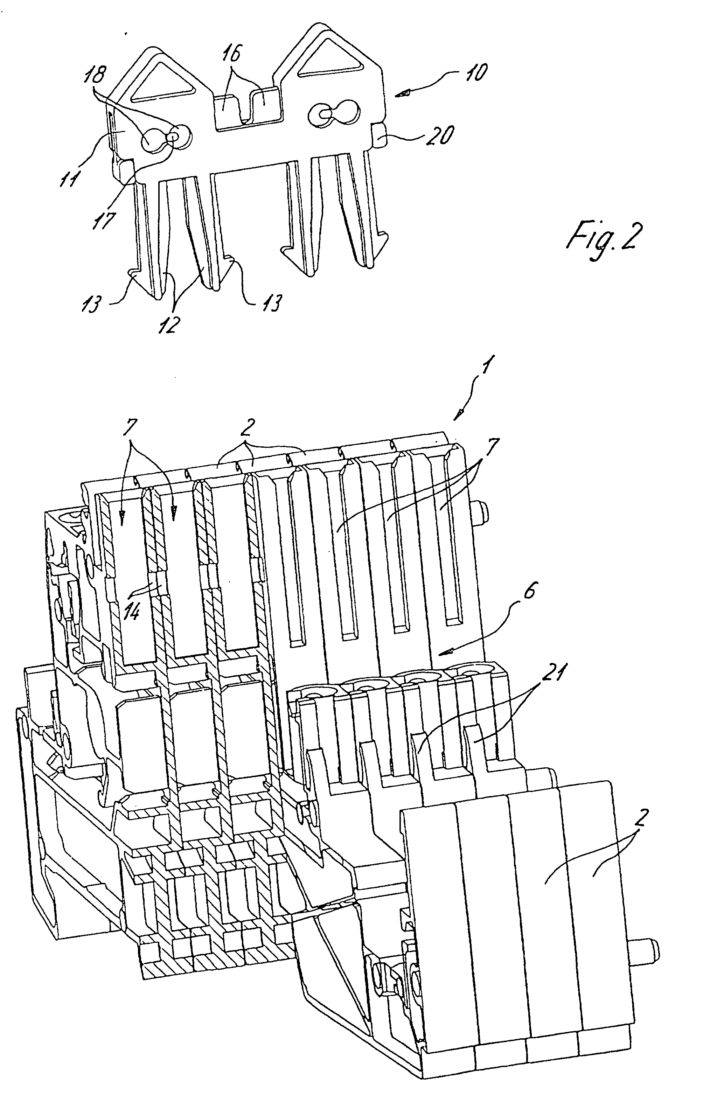

- Figur 2: eine perspektivische, teilgeschnittene Darstellung eines Anschlußblockes der Steuerungsanlage mit montagebereit darüber befindlichem Sicherungselement,
- Figur 3: den Anschlußblock der Steuerungsanlage mit eingestecktem Sicherungselement und montagebereit darüber befindlichem Elektronikmodul,

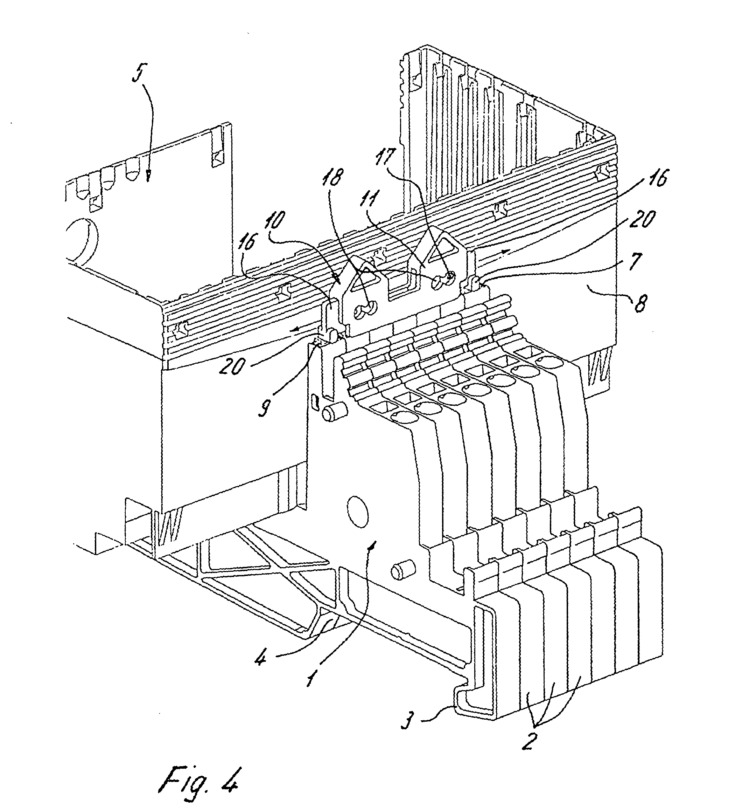

- Figur 4: die Steuerungsanlage mit dem Anschlußblock, dem eingesteckten Sicherungselement und dem eingesteckten und durch das Sicherungselement blockierten Elektronikmodul.

Die Steuerungsanlage für elektronische Steuerungs- und Automatisierungssysteme beinhaltet im dargestellten Ausführungsbeispiel einen Anschlußblock 1, der aus einer Anreihung von Anschlußscheiben 2 zusammengesetzt ist. Die Anschlußscheiben 2 sind in ihren Außenkonturen identisch, im übrigen je nach Anwendungsfall elektrotechnisch funktionsgerecht bestückt, so daß beispielsweise in einem derartigen Anschlußblock 1 mindestens eine Schutzleiterscheibe, eine Einspeisescheibe sowie eine Anzahl von Versorgungs-/Signalleiterscheiben vorhanden sind. Die einzelnen Anschlußscheiben 2 haben am unteren Ende ihres aus Isolierstoff bestehenden Gehäuses eine Rastkontur 3, 4, mit der der Anschlußblock 1 in Schaltanlagen auf Normtragschienen aufgerastet werden kann.

Zu der Steuerungsanlage gehört ferner ein Elektronikmodul 5, das mechanisch mit dem Anschlußblock 1 durch eine Steckverbindung zu verbinden ist. Die Anschlußscheiben 2 bilden in ihrer Anreihung in dem Anschlußblock 1 einen Aufnahmeraum 6, in den das Elektronikmodul 5 vertikal eingesteckt werden kann. An der einen Begrenzungsfläche des Aufnahmeraumes 6 sind jeweils an den Anschlußscheiben 2 zu dem Aufnahmeraum 6 weisende T-nutenförmige Führungen 7 gebildet. Da im dargestellten Ausführungsbeispiel der Anschlußblock 1 aus sieben Anschlußscheiben 2 besteht, sind demzufolge sieben T-nutenförmige Führungen 7 vorhanden.

An der zugehörigen Begrenzungswand des Gehäuses 8 des Elektronikmodules 5 sind zwei T-Nutengegenstücke 9 vorgesehen, und zwar in Anpassung an dieses Ausführungsbeispiel eines Anschlußblockes 1 in einem solchen Abstand voneinander, daß sie beim vertikalen Einstecken des Gehäuses 8 des Elektronikmodules 5 in den Aufnahmeraum 6 in die beiden außen liegenden T-nutenförmigen Führungen 7 eintreten.

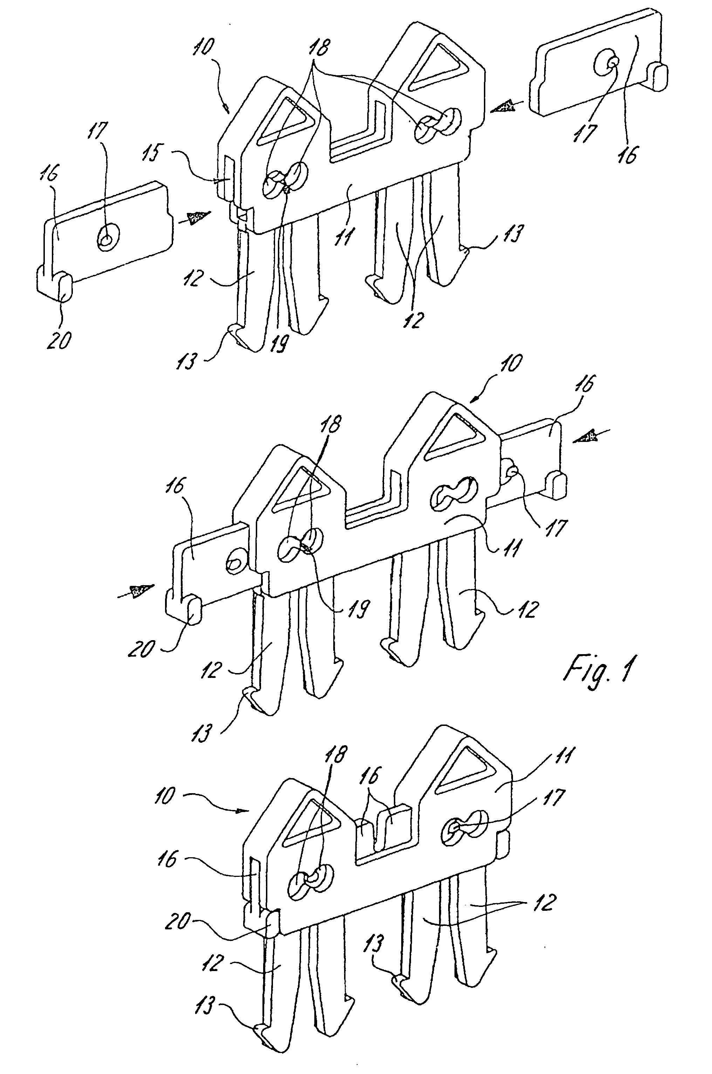

Es ist nun ein gesondertes Sicherungselement 10 vorgesehen, das in den vorhandenen T-nutenförmigen Führungen 7 festsetzbar ist und das Mittel zum Blockieren des eingesteckten Elektronikmoduls 5 in Ausziehrichtung aufweist. In dem in den Figuren, insbesondere Figur 1, dargestellten Ausführungsbeispiel ist ein Sicherungselement 10 vorgesehen, das einen einstückigen Grundkörper 11 mit zwei nach unten vorstehenden Rastbeinpaaren 12 aufweist, wobei die Rastbeine 12 jeweils nach außen vorstehende Rasthaken 13 haben. Die Außenkontur des Grundkörpers 11 des Sicherungselementes 10 ist so bemessen, daß das Sicherungselement 10 genau zwischen die beiden T-Nutengegenstücke 9 des Gehäuses 8 des Elektronikmoduls 5 paßt. Die Anordnung ist dabei ferner so getroffen, daß die Rastbeinpaare 12 mit den Rasthaken 13 unter Freilassung der seitlich jeweils außen liegenden T-nutenförmigen Führungen 7 in die jeweils zwei nach innen angrenzend liegenden T-nutenförmigen Führungen 7 eingesteckt werden können. Dabei sind in den Materialstegen der T-nutenförmigen Führungen 7 an entsprechender Stelle ihres Längsverlaufes Rastaussparungen 14 vorgesehen, in die die Rasthaken 13 der Rastbeinpaare 12 nach Einstecken des Sicherungselementes 10 einrasten können, so daß das Sicherungselement 10 danach einen festen, unverlierbaren Halt in dem Anschlußblock 1 hat.

In dem Grundkörper 11 des Sicherungselementes 10 sind jeweils zu den Schmalseiten hin offene Führungen 15 gebildet, in die von den Schmalseiten auf beiden Seiten jeweils Schieberelemente 16 eingeschoben werden können, wie in Figur 1 in jeweils drei verschiedenen Phasen illustriert ist.

Beide Schieberelemente 16 weisen jeweils auf ihren beiden Seiten Rastnocken 17 auf und in dem einstückigen Grundkörper 11 sind beidseitig für jedes der Schieberelemente 16 auf beiden Seiten Rastbohrungspaare 18 vorgesehen, wobei die Rastbohrungspaare 18 jeweils durch einen schmalen Durchtrittskanal 19 miteinander verbunden sind. Die Rastbohrungspaare 18 ermöglichen in Verbindung mit den Rastnocken 17 eine Verrastung der beiden noch zu beschreibenden Funktionsstellungen der Schieberelemente 16 im Grundkörper 11 des Sicherungselementes 10. An ihren unteren Außenelementen haben die Schieberelemente 16 Anschlagstücke 20, die unter anderem die vollständig eingeschobene Lage der Schieberelemente 16 definieren, wie aus Figur 1 ersichtlich.

Mit den vorstehend beschriebenen Teilstücken der Steuerungsanlage ist folgende Montage möglich, wobei von einer fertigen Montage des Sicherungselementes selbst (siehe Figur 1) ausgegangen wird:

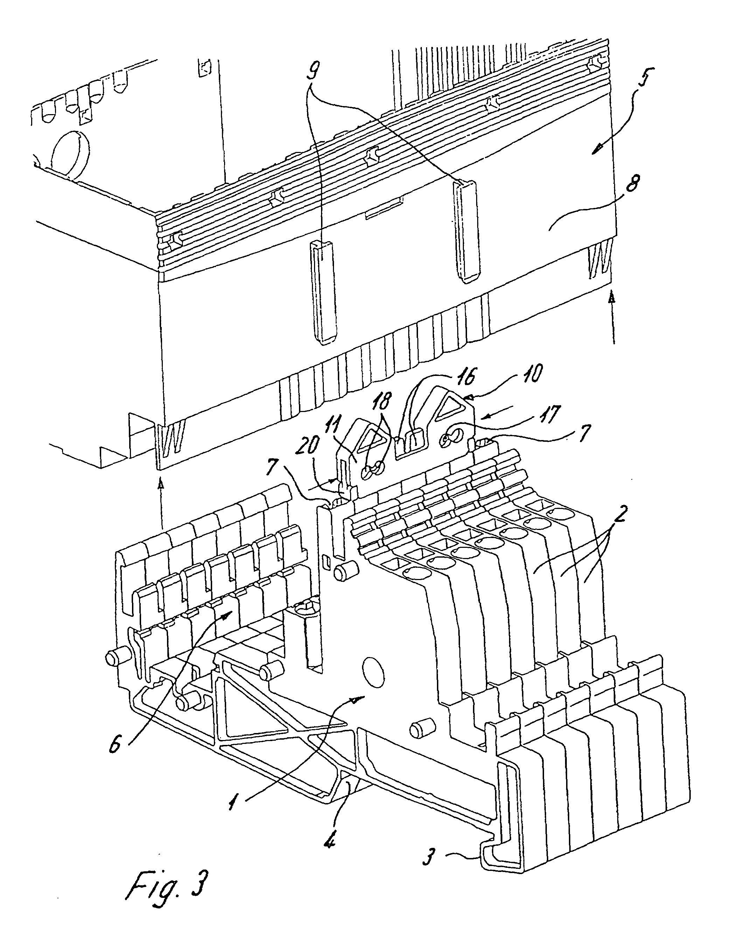

Das fertig montierte Sicherungselement wird in die T-nutenförmigen Führungen 7 des Anschlußblockes 1 so eingesetzt, daß die beiden außen liegenden T-nutenförmigen Führungen 7 frei bleiben. Die Schieberelemente 16 befinden sich dabei in der vollständig eingeschobenen einen Funktiosstellung (siehe Figur 3). Das Sicherungselement 10 ist mit den Rasthaken 13 seiner Rastbeine 12 unverlierbar im Anschlußblock an funktionsgerechter Stelle festgesetzt.

Danach wird das Elektronikmodul 5 mit seinem Gehäuse 8 in den Aufnahmeraum 6 des Anschlußblockes 1 eingesetzt, wobei seine beiden T-Nutengegenstücke 9 in die beiden außen liegenden T-Nutenführungen 7 eintreten. Dieser Montagevorgang ist gewährleistet, da die Außenkontur des Sicherungselementes 10 zwischen die beiden T-Nutengegenstücke paßt (siehe Figur 3).

Nach Einstecken des Elektronikmoduls 5 werden, beispielsweise mittels eines Schraubendrehers oder eines vergleichbaren Werkzeuges die beiden Schieberefemente 16 gegenläufig zueinander nach außen verlagert, so daß sie mit ihren äußeren Enden und insbesondere den Anschlagstücken 20 dann über die beiden T-Nutengegenstücke 9 des eingesteckten Elektronikmoduls 5 greifen und damit dieses in der eingesteckten Lage in der Ausziehrichtung blockieren, so daß das Elektronikmodul 5 auch bei rauhestem Werkstattbetrieb unverlierbar im Anschlußblock 1 gehalten ist. In dieser Funktionslage der Schieberelemente 16 sind diese wiederum in den entsprechenden Rastbohrungen 18 der Rastbohrungspaare mittels ihrer Rastnocken 17 verrastet.

Soll das Elektronikmodul ausgebaut werden, genügt es, die beiden Schieberelemente 16 aus der Blockierlage in das Innere des Grundkörpers 11 des Sicherungselementes zu verschieben, so daß sie wieder die in Figur 3 gezeigte Lage einnehmen. Das Elektronikmodul 5 kann danach problemlos nach oben entnommen werden.

Im dargestellten Ausführungsbeispiel sind noch im Bereich des Aufnahmeraumes 6 des Anschlußblockes 1 an den Anschlußscheiben 2 die üblichen Rasten 21 vorgesehen, die mit in einer Gehäusewand 22 des Elektronikmodulgehäuses 8 befindlichen Rastaussparungen (nicht dargestellt) zur Verrastung des Elektronikmoduls 5 im Aufnahmeraum 6 des Anschlußblockes 1 zusammenwirken. Im Hinblick auf die Blockierfunktion des Sicherungselementes 10 kann daran gedacht werden, auf eine derartige Verrastung zu verzichten. Die benötigte Kraft für die Steckverbindung zwischen dem Elektronikmodul 5 und dem Anschlußblock 1 kann dadurch noch weiter verringert werden.

## Patentansprüche

1. Steuerungsanlage für elektronische Steuerungs- und Automatisierungssysteme, beinhaltend mindestens einen Anschlußblock (1) mit Versorgungsund/oder Signalleiteranschlüssen und mindestens einem Elektronikmodul (5) zur Signalbe- und -verarbeitung, wobei das Elektronikmodul (5) und der Anschlußblock (1) über T-nutenförmige Führungen (7) und T-Nutengegenstücke (9) mechanisch miteinander verbunden sind, **gekennzeichnet durch** ein gesondertes, in den T-nutenförmigen Führungen (7) festsetzbares Sicherungselement (10), das Mittel (16) zum Blockieren des eingesteckten Elektronikmoduls (5) in Ausziehrichtung aufweist.

2. Steuerungsanlage nach Anspruch 1, **dadurch gekennzeichnet, daß** die Außenkontur des Sicherungselementes (10) so bemessen ist, daß es zwischen die zwei am Gehäuse (8) des Elektronikmoduls (5) vorgesehenen T-Nutengegenstücke (9) paßt.

3. Steuerungsanlage nach Anspruch 1 oder 2, **dadurch gekennzeichnet, daß** das Sicherungselemet (10) Rastbeinpaare (12) aufweist, die so voneinander beabstandet sind, daß das Sicherungselement (10) mit den Rastbeinpaaren (12) unter Freilassung der beiden außen liegenden T-nutenförmigen Führungen (7) des Anschlußblockes (1) in angrenzende T-nutenförmige Führungen (7) einsteckbar ist.

4. Steuerungsanlage nach Anspruch 3, **dadurch gekennzeichnet, daß** die Rastbeine (12) des Sicherungselementes (10) nach außen vorstehende Rasthaken (13) aufweisen, für die in angrenzenden Materialstegen der T-nutenförmigen Führungen (7) Rastaussparungen (14) vorgesehen sind.

5. Steuerungsanlage nach einem der vorhergehenden Ansprüche, **dadurch gekennzeichnet, daß** als Blockiermittel in dem Sicherungselement (10) in dessen Grundkörper (11) zwei Schieberelemente (16) angeordnet sind, die in zu den Schmalseiten hin offenen Führungen (15) des Grundkörpers (11) angeordnet und zwischen einer in die Außenkontur des Sicherungselementes (10) eingefahrenen Stellung sowie einer Ausfahrstellung verlagerbar sind, in der sie die T-Nutengegenstücke (9) des eingesteckten Elektronikmoduls (5) blockierend übergreifen.

6. Steuerungsanlage nach Anspruch 5, **dadurch gekennzeichnet, daß** die Schieberelemente (16) in ihren Funktionsstellungen verrastet sind.

7. Steuerungsanlage nach Anspruch 6, **dadurch gekennzeichnet, daß** in dem Grundkörper (11) des Sicherungselementes (10) beidseitig Rastbohrungspaare (18) vorgesehen sind, die durch einen schmalen Durchtrittskanal (19) jeweils miteinander verbunden sind, wobei an den Schieberelementen (16) mit den Rastbohrungspaaren (18) zusammenwirkende Rastnocken (17) vorgesehen sind.

8. Steuerungsanlage nach Anspruch 5, **dadurch gekennzeichnet, daß** an den äußeren unteren Enden der Schieberelemente (16) Anschlagstücke (20) vorgesehen sind.

## Claims

1. Control system for electronic control and automation systems, comprising at least one connecting block (1) with supply and/or signalling line connections and at least one electronic module (5) for processing signals, the electronic module (5) and the connecting block (1) being mechanically connected to one another via T-groove-shaped guides (7) and T-groove mating elements (9), **characterized by** a separate securing element (10) which can be fixed in the T-groove-shaped guides (7) and which has means (16) for locking the inserted electronic module (5) in the withdrawal direction.

2. Control system according to Claim 1, **characterized in that** the external contour of the securing element (10) is dimensioned in such a way that it fits between the two T-groove mating elements (9) which are provided on the housing (8) of the electronic module (5).

3. Control system according to Claim 1 or 2, **characterized in that** the securing element (10) has latching leg pairs (12) which are spaced apart from one another in such a way that the securing element (10) can be plugged, with the latching leg pairs (12), into adjacent T-groove-shaped guides (7) leaving free the two T-groove-shaped guides (7) of the connecting block (1) which lie on the outside.

4. Control system according to Claim 3, **characterized in that** the latching legs (12) of the securing element (10) have outwardly protruding latching hooks (13) for which latching recesses (14) are provided in adjacent material webs of the T-groove-shaped guides (7).

5. Control system according to one of the preceding claims, **characterized in that** two slider elements (16), which are arranged in guides (15) - which are open towards the narrow sides - of the base body (11) and can be displaced between a position which is retracted into the external contour of the securing element (10) and an extended position in which they engage over the T-groove mating elements (9) of the inserted electronic module (5) in a locking fashion, are arranged as locking means in the base body (11) of the securing element (10).

6. Control system according to Claim 5, **characterized in that** the slider elements (16) are latched in their functional positions.

7. Control system according to Claim 6, **characterized in that** latching hole pairs (18), which are respectively connected to one another by a narrow passage duct (19), are provided on both sides in the base body (11) of the securing element (10), latching cams (17) which interact with the latching hole pairs (18) being provided on the slider elements (16).

8. Control system according to Claim 5, **characterized in that** stop elements (20) are provided on the outer, lower ends of the slider elements (16).

## Revendications

1. Unité de commande pour systèmes électroniques de commande et d'automatisation, comprenant au moins un bornier (1) avec des connexions d'alimentation et/ou de signalisation et au moins un module électronique (5) pour la mise en forme et le traitement de signaux, dans laquelle le module électronique (5) et le bornier (1) sont reliés ensemble de façon mécanique par l'intermédiaire de guides en forme de rainure en T (7) et de pièces complémentaires de rainure en T (9), **caractérisée par** un porte-fusibles séparé (10) pouvant être immobilisé dans les guides en forme de rainure en T (7) et présentant des moyens (16) pour bloquer le module électronique emboîté (5) dans la direction d'extraction.

2. Unité de commande selon la revendication 1, **caractérisée en ce que** le contour extérieur du porte-fusibles (10) est dimensionné de telle sorte qu'il s'adapte entre les deux pièces complémentaires de rainure en T (9) prévues sur le coffret (8) du module électronique (5).

3. Unité de commande selon la revendication 1 ou 2, **caractérisée en ce que** le porte-fusibles (10) présente des paires de broches d'arrêt (12) qui sont espacées les unes des autres, de telle sorte que le porte-fusibles (10) peut être emboîté avec les paires de broches d'arrêt (12) dans des guides en forme de rainure en T (7) adjacents tout en dégageant les deux guides en forme de rainure en T (7), situés à l'extérieur, du bornier (1).

4. Unité de commande selon la revendication 3, **caractérisée en ce que** les broches d'arrêt (12) du porte-fusibles (10) présentent des crochets d'arrêt (13), faisant saillie vers l'extérieur, pour lesquels des évidements d'arrêt (14) sont prévus dans des entretoises adjacentes des guides en forme de rainure en T (7).

5. Unité de commande selon l'une quelconque des revendications précédentes, **caractérisée en ce que** comme moyens de blocage dans le porte-fusibles (10), deux éléments coulissants (16) sont disposés dans le corps de base (11) de celui-ci, ces éléments étant disposés dans des guides (15), ouverts vers les côtés courts, du corps de base (11) et pouvant être déplacés entre une position rentrée dans le contour extérieur du porte-fusibles (10) et une position sortie dans laquelle ils dépassent par blocage les pièces complémentaires de rainure en T (9) du module électronique (5) emboîté.

6. Unité de commande selon la revendication 5, **caractérisée en ce que** les éléments coulissants (16) sont arrêtés dans leurs positions opérationnelles.

7. Unité de commande selon la revendication 6, **caractérisée en ce que** dans le corps de base (11) du porte-fusibles (10), des paires d'alésage d'arrêt (18) sont prévues des deux côtés, qui sont respectivement reliées ensemble par un canal de passage étroit (19), des cames d'arrêt (17) coopérant avec les paires d'alésages d'arrêt (18) étant prévues sur les éléments coulissants (16).

8. Unité de commande selon la revendication 5, **caractérisée en ce que** des pièces de butée (20) sont prévues sur les extrémités inférieures extérieures des éléments coulissants (16).
